Europäisches Patentamt

European Patent Office

Office européen des brevets

(11) Publication number: **0 267 882**
**A1**

# (12) EUROPEAN PATENT APPLICATION

(21) Application number: 87830379.1

(22) Date of filing: 27.10.87

(51) Int. Cl.⁴: **H 01 L 27/06**
**H 01 L 21/82**

(30) Priority: 10.11.86 IT 8365786

(43) Date of publication of application:
18.05.88 Bulletin 88/20

(84) Designated Contracting States: **DE FR GB NL SE**

(71) Applicant: **SGS MICROELETTRONICA S.p.A.**
**Stradale Primosole 50**
**I-95121 Catania (IT)**

(72) Inventor: **Contiero, Claudio**
**Via Giovanni XXIII, 5**
**I-20090 Buccinasco (IT)**

**Galbiati, Paola**
**Via Ramazzotti, 24**
**I-20052 Monza (IT)**

**Andreini, Antonio**
**Via Capecelatro, 38**
**I-20148 Milano (IT)**

(74) Representative: **Pellegri, Alberto et al**
**c/o Società Italiana Brevetti S.p.A. Via Cavour, 9**
**I-21100 Varese (IT)**

(54) Monolithic integration of isolated, high performance, power vdmos transistors and of high voltage p-channel mos transistors together with cmos, npn, pnp transistors and low leakage diodes.

(57) Isolated from one another N-channel, VDMOS power transistors having a self-aligned and shielded structure and being suitable for high operating voltages and high currents, are monolithically integrated together with drive, P-channel MOS transistors having a drain extension region for tolerating reverse voltages higher than the breakdown voltage of the VDMOS power transistors, and together with CMOS transistors, vertical and lateral NPN transistors, PNP transistors and low leakage diodes for implementing self-contained control systems capable of being driven by logic level signals. The integration is accomplished with a minimum alteration of a known VDMOS transistor's fabrication process.

FIG. 26

EP 0 267 882 A1

Description

# MONOLITHIC INTEGRATION OF ISOLATED, HIGH PERFORMANCE, POWER VDMOS TRANSISTORS AND OF HIGH VOLTAGE P-CHANNEL MOS TRANSISTORS TOGETHER WITH CMOS, NPN, PNP TRANSISTORS AND LOW LEAKAGE DIODES

## BACKGROUND OF THE INVENTION

### 1. Field of the invention

The present invention relates to monolithically integrated circuits (I.C.) and to fabrication processes thereof.

More particularly, the present invention relates to the formation, over a single chip, of power VDMOS transistors, electrically isolated from one another, and capable of operating at a high voltage (above 100 V) with a low power dissipation, and of P-channel MOS transistors capable of tolerating high reverse voltages for driving said power VDMOS transistors, together with other active components such as CMOS transistors, bipolar NPN and PNP transistors, in order to permit implementation on a single chip also of signal processing and/or control logic circuitry.

Fast advances in I.C. and power devices technology, together with the implementation of VLSI fabrication techniques in the fabrication processes of power MOS transistors, have created basic tehnological premises for researching and developing new families of integrated circuits wherein power and control functions be advantageously integrable on a single chip. This kind of technological evolution may satisfy the designer requirements of combining the most favorable features of existing fabrication technologies so as to be able to create monolithically integrated complex systems and subsystems without compromising in terms of performances of the different types of active components. In fact, CMOS devices offer a low dissipation and a high density of integration and represent the optimal choice for logic circuitry in a monolithically integrated system. Even when they are utilized for analog functions, they offer a high linearity and a high transient speed. Conversely, bipolar transistors remain best suited for high gain stages because of their high transconductance and low noise factor, offering unsurpassed performances in high precision linear circuitry, being their $V_{BE}$ voltage precisely matchable.

In order for a system to be recognized as "completely monolithic", it must comprise one or more separate power stages (i.e. interface stages with the outside world).

One of the best suited device for making power stages in I.C., is the VDMOS transistor. This power device is usually made by a plurality of unitary cells, connected in parallel to one another, which may have different geometries; rectangular, hexagonal, triangular, etc., in order to obtain an optimal utilization of the available area on the silicon chip.

VDMOS transistors offer, in fact, a high intrinsic reverse breakdown voltage because the voltage is susstained by the full thickness of the epitaxial layer, a fabrication compatibility with CMOS transistors, a high switching speed, no current drain under DC conditions and no limitation imposed by secondary breakdown modes. By using VDMOS transistors it is possible to fabricate I.C. capable of delivering high output powers without being subject to an excessive heating which represents the main obstacle to the miniaturization of power circuits.

### 2. Description of the Prior Art

Lately, a number of so-called mixed technologies have been proposed, directed to monolithically integrating VDMOS power transistors together with other useful active devices such as bipolar transistors, CMOS transistors and high voltage transistors.

Examples of such technical proposals are contained, for example, in the US patent 4,546,370 by Curran; in the article: "AN Analog Technology Integrates Bipolar, CMOS, and High-Voltage DMOS Transistors", by Surinder Krishna et al. IEEE Transactions on Electronic Devices, Vol. ED-31, No. 1, January 1984; and in the article: "DMOS-CMOS process points to highest power rating for "smart" power control" by Stephan Ohr, Electronic Desing, February 9, 1984.

Obstacles of fabrication technology incompatibility and/or prejudicial technical considerations have not allowed to obtain high performances from VDMOS power transistors integrated by means of such known mixed technologies. Looking for the necessary compatibility with other active devices to be formed on the same silicon chip has meant sacrificing on the optimization of the characteristics of the power device in order to preserve acceptable performance characteristics of the other devices. Moreover, the power VDMOS transistors are often "tied" to ground, having their sources or their drains connected to the substrate of the integrated circuit. This fact severely limits design possibilities, by not allowing, for example, the realization of two or more distinct (isolated from one another) power VDMOS transistors in the same integrated circuit.

Moreover, the driving of power VDMOS transistors is more efficiently made by means of MOS transistors capable of tolerating comfortably high reverse voltages; none of the known proposals relating to such mixed technologies contemplates the possibility of optimizing also such an important characteristics of these drive MOS transistors.

## DESCRIPTION OF THE INVENTION

One of the main aspects of the present invention is a compatible fabrication of high performance power VDMOS transistors, completely isolated by a standard junction isolation technique from other integrated devices, and of P-channel MOS transistors capable of tolerating reverse voltages higher than the breakdown reverse voltage of the power VDMOS transistor itself and of CMOS transistors, bipolar NPN and PNP transistors and other active and passive circuit components.

A second aspect of the present invention is represented by the fact that the fabrication of self-aligned cell structure of power VDMOS transistors comprises an efficient and reliable junction edge termination using body extension P-regions and polysilicon field plates with a bi-planar structure as well as P-channel MOS transistors having P--type, self-aligned, drain extensions. Fabricating these high performance structures and other active devices may be achieved by the introduction of a minimum number of additional masking steps in the sequence of fabrication steps of a substantially standard polysilicon gate, DMOS fabrication process, upon which the mixed fabrication process of the present invention bases itself in contrast with known mixed technologies of the prior art.

The architecture of an integrated circuit according to the present invention is the result of the merging of two distinct known technologies: the vertical DMOS, silicon gate, process and the standard junction isolation technique, with the introduction of at least two additional masking steps.

The simplest version of this process consists of twelve masking steps: seven from the DMOS process and three from the standard junction isolation technique, plus two or more additional masking steps for integrating a variety of different semiconductor structures with a minimal disturbance of the basic process.

The starting material is 2-4 ohms.cm, P type <100> silicon substrate. An N+ buried layer is locally introduced by antimony implanting after a first patterning step.

Antimony diffusion follows and an N type epitaxial layer is grown on the surface of the substrate. The resistivity and the thickness of this layer are chosen to give the best trade-off between breakdown voltage and ON resistance of the vertical DMOS power transistors.

The next step is the patterning and introduction by ion implantation of boron and subsequent pre-diffusion heat treatment to form P-Well regions. Then, after having oxidized the wafer, the windows for the P+ isolation regions are opened. Boron is deposited and diffused until epitaxial N type islands, isolated from one another by said deep P+ diffusions, are formed. The wafer is again oxidized; and after a further patterning and window opening procedure through the oxide layer, phosphorus is deposited and diffused to contact the buried N+ regions. These N+ sinker regions have a very low sheet resistance to minimize the resistance in series to the collector and to the drain, respectively, of bipolar transistors and of VDMOS transistors. The previous high temperature steps provide the diffusion to reach a junction depth equal to about 4.5 $\mu$m for said P-Well regions that are used as bases for high gain NPN transistors, as well as to form self isolated N-channel transistors in CMOS structures, and, optionally, to form a first drain extension region in high breakdown voltage P-channel MOS transistors.

Before patterning the active area, heavily doped P+ contact regions are created by window opening through the oxide layer and by boron ion implantation. These P+ regions constitute also the emitter and collector regions for lateral PNP transistors and channel stopper regions in CMOS structures.

A field oxide, grown to a thickness of about 1 $\mu$m, is patterned using a technique that allows the formation of tapered steps to improve the performance of the high voltage devices and step coverage by subsequently deposited layers. A thin (850 Å thick) gate oxide layer is grown and a light dose of boron is implanted without any extra mask to adjust, at the same time, the threshold voltage of the P-channel and of the N-channel MOS devices in CMOS structures.

A thick LPCVD (Low Pressure Chemical Vapor Deposition) polycrystalline silicon layer is then deposited and, after a doping step with phosphorus by POCl3 gaseous pre-deposition, the polysilicon is patterned by plasma etching through an appropriate mask to leave the gates, the field plates and the interconnections. By means of the next photolithographic masking step and boron ion implantation, active P type regions are defined: these are the body or channel regions for the VDMOS transistors, the source and drain regions for the P-channel MOS transistors, self aligned with the polysilicon, and the base for the NPN transistors, self aligned with the field oxide. During a high temperature drive-in step, takes place the diffusion of the previously implanted P+ regions together with the active P tubs regions, in order to reach a junction depth of about 3.0 and 2.5 $\mu$m, respectively.

Without any extra masking step, a light boron implant follows to form the drain extension regions, self registered (aligned) with the polysilicon and with the field oxide, for the high voltage P-channel MOS transistors. After a patterning step, a heavy arsenic ion implant (about $5.10^{15}$ cm$^{-2}$) locally introduces arsenic to form: N+ contact regions, the emitter region for the NPN bipolar transistors, the source region for the VDMOS transistors and the source and drain regions for the N-channel MOS transistors of CMOS structures (sources and drains are self aligned with the polysilicon). A drive-in and oxidation high temperature treatment follows; thereafter a phosphorus doped silicon oxide layer is deposited and then, after a gettering step, reflowed to form a continuous glassy coating on top of the wafer. The junction depth of the arsenic doped N+ regions is about 0.5 um. The whole structure is subjected next to a conventional contact opening step, to a metal deposition and a patterning step, followed by a passivation procedure.

In contrast with what happens with known mixed technology integrated circuits, the structure of the power VDMOS transistors has the more advantageous configuration resulting from forming heavily P+ doped central body regions (i.e. outside the channel zone of the device), thus allowing to form, under self alignment conditions with the gate polysilicon and with the field plate polysilicon structure, P regions of body extension, i.e. regions having a reduced boron doping level, laterally diffused as short lateral extensions of the P+ doped central body region, before forming the N+ source regions under self-alignment conditions with the polysilicon too.

The channel length in VDMOS structures and, consequently, their voltage-current characteristics are precisely pre-determined by exploiting the difference in diffusivity (in a lateral direction) of the two different impurities (dopants) introduced through the same opening of the polysilicon mask, respectively of P dopant (B) for the body extension regions and of N+ dopant (As) for the source regions.

The fact that the central body region (underneath the N+ source regions) be relatively strongly doped with boron, effectively reduces the gain of the parasitic NPN transistor because the relative base region, identifiable in the central P+ region underlying the N+ source region, is strongly charged, i.e. has an extremely low resistivity.

### VDMOS Power Transistors

In the design of power VDMOS transistors, the key parameters are the breakdown voltage, the device ON resistance for a given area and the threshold voltage. In the integrated circuit of the invention all three parameters of the VDMOS structure are most easily optimized though preserving compatibility with forming distinct VDMOS power transistors, isolated from one another and from other integrated devices.

For a given resistivity and thickness of the epitaxial layer, the maximum reverse bias breakdown voltage (drain-source) may be severely limited to a voltage level corresponding to the breakdown voltage at the junction edge, which often is much lower than the theoretical breakdown voltage across the thickness of the epitaxial layer owing to the curvature effect of the P diffusion at the edge of the cell (crowding of equipotential lines near sharp edges of the conductive structures).

In the integrated structures of the invention, the simultaneous presence of lateral P body extensions and the use of polysilicon field plates overlying silicon dioxide of two different thicknesses (gate oxide layer thickness and field oxide layer thickness), forming a biplanar, electrostatic screen, structure, allows to increase decisively the effective radius of curvature of the junction edge. This greatly increases the reliability of the VDMOS devices. Preferably, also the second level of source metallization is advantageously extended over the underlying polysilicon field plate and, for a certain distance, also beyond the lateral edge of the latter, having found that also this second level metal layer, suitably extended, appears to contribute positively to further increase the effective radius of curvature of such a junction edge termination. This edge termination exhibits an efficiency, expressed as a ratio between the value of experimentally measured breakdown voltage divided by the calculated value of the breakdown voltage across the epitaxial layer (ideal bulk breakdown voltage value), of 0,85 and greater.

Owing to the possibility of counting upon an exceptionally efficient edge termination, it becomes possible to minimize the epitaxial layer resistance contribution to the ON series resistance (Ron) of VDMOS transistors by suitably decreasing the thickness of the epitaxial layer until permitting to the depleted region of the body-drain junction to reach the N+ buried layer across the reduced thickness of the epitaxial layer.

Beside the additional contribution to the Ron resistance of power VDMOS devices, due to a lateral migration resistance through the N+ buried layer and to the resistance of the N+ contact (sinker) diffusion, the Ron resistance of the power device depends notably on the topography of the power device, i.e. from the shape and dimensions (i.e. packing density) of the unitary VDMOS cells which constitute the power device (VDMOS transistor). Also under this aspect, the integrated circuit of the invention, contemplating a fabrication under self alignment conditions of the structure of the unit cells of the power transistor, offer a minimization of the size of the single unit cells and an increase of the packing density thereof. An optimal minimum value of the product: Ron x occupied area, using a cell size of 15 µm, is obtained for an intercell spacing comprised between 9 and 10 µm. For a number of cells disposed side by side between two single fingers equal to 7, the value of the above noted product equals to $5,92.10^{-3}$ ohm.cm$^2$.

The value of the threshold voltage of VDMOS power transistors is primarily related to the thickness of the gate oxide and to the peak impurity concentration of the laterally diffused body regions in the zone comprised between the source and the drain regions. The doping profile of the body region is necessarily multifunctional in an integrated circuit and it may be preset in function of the peculiar requisits of the integrated circuits in view of the contemplated application, as it will be discussed later in the present specification.

### High Voltage P-MOS Transistors

To satisfy the driving requirements of the high voltage VDMOS power device, it is necessary to have a component of inverse polarity sustaining a supply voltage exceeding the VDMOS maximum voltage by a value at least equal to its driving voltage.

According to the present invention, by adding a boron implant step and without requiring any extra masking step, it is possible to form drain extension regions in a P-channel MOS device, in order to increase its reverse bias breakdown voltage beyond the maximum voltage value which may be delivered from the power VDMOS transistors. Such a low doping extension of the drain region toward the gate lowers the intensity of the superficial electric field in the overlapping region between drain and gate, thus greatly increasing the reverse voltage capability.

### CMOS Transistors

Self-isolated CMOS structures are formed by adding a P-Well formation step to the sequence of operations of the VDMOS fabrication process. The P-Well provides the channel region for the N-MOS transistors with the source and drain obtained by means of the above mentioned arsenic diffusion. In P-MOS transistors, the epitaxial layer represents the channel region and the source and drain are obtained by means of the boron diffusion employed to make the VDMOS channel region.

The threshold voltage of P-channel CMOS transistors is set by the epitaxial layer resistivity whose value is limited by the reverse breakdown requirement of the high voltage DMOS structures. Its value can be adjusted by means of a light implant of boron ions. The trade-off between the doping levels of the P-Well and of the threshold voltage adjustment doping level of the P-channel devices gives complementary threshold voltages among devices of opposite polarity without requiring the use of additional masking steps. In fact, the doping adjustment which may be required is so light that it does not cause any perturbation to the other integrated structures of the circuit.

The combination of an epitaxial layer grown over a low shunt resistance N+ buried layer and of a P+ ring around the P-Well regions gives a remarkably improved reliability in terms of latch-up susceptibility of the parasitic thyristor, which is intrinsic to CMOS structures.

Bipolar Transistors

The electrical characteristics of the lateral PNP transistors are connected to the epitaxial layer resistivity and to the spacing between the P+ junctions of emitter and of collector.

By using as a base and as an emitter the same dopant profiles involved in the DMOS transistor structures to form, respectively, the body and the source regions there of, it is possible to realize vertical NPN transistors with very reproducible electrical characteristics: a relatively low, but extremely constant (over more than two decades of Ic current) gain (hFE $\simeq$ 30);

reverse bias breakdown voltages BVCEO $\simeq$ 35 V, BVCBO $\simeq$ 60 V and BVEBO $\simeq$ 7.5 V; and

a cut-off frequency of about 300 MHz.

The low spread of the hFE parameter, of about $\pm$ 5%, with respect to standard bipolar transistor fabrication process is due to the much more controlled characteristics of the fabrication process of the integrated circuit of the invention which is essentially a VLSI MOS process. This peculiarity largely compensates for the relatively low value of the hFE parameter. By adding, as an option, an extra masking step followed by oxide etching in the process flow chart before the gettering step and without perturbing the heat treatment steps, it is possible to integrate also vertical NPN transistors with a high gain (hFE = 200-350) and with a high cut off frequency of about 1 GHz.

In these alternative NPN transistor structures, the base has the same doping profile as the previous vertical NPN structure, but the emitter region is deeper ($\simeq$ 1.8 $\mu$m) and phosphorus doped, by depositing phosphorus during the gettering and "siloxreflow process steps. These high gain vertical NPN transistors exhibit reverse bias breakdown voltages as follows:

BVCBO $\simeq$ 60 V, BVCEO $\simeq$ 25 V and BVEBO $\simeq$ 7.5 V.

Yet a third type of bipolar vertical NPN transistors may be formed by utilizing the same arsenic doped emitter of the low gain first type of NPN transistors but utilizing as a base the doping profile of the P-Well region of the CMOS structures. This third type of NPN transistors show a relatively high gain (hFE $\simeq$ 250) and the following breakdown voltages:

BVCBO $\simeq$ 90 V, BVCEO $\simeq$ 40 V and BVEBO $\simeq$ 16 V. Owing to the greater width of the base ($\simeq$ 4 $\mu$m), in these NPN transistors the cut-off frequency is slightly lower than in the other types of NPN transistors ($\simeq$ 140 MHz).

Differently from the known mixed technologies devices, the present inventors have achieved the objective of making compatibly integrable the most sophisticated configurations of state-of-the-art VDMOS structures with those of P-channel MOS transistors capable of tolerating very high supply voltages, with CMOS transistors, with vertical NPN and PNP bipolar transistors and with other semiconductor circuit elements of excellent electrical characteristics besides allowing the integration on the same chip of more than one VDMOS power transistors, isolated from one another. With the integrated circuit of the invention, compromises in the configuration and in the electrical characteristics of the power VDMOS transistors, dictated by compatibility restraints of the fabrication process thereof, are no longer necessary and the power transistors may be accurately optimized in function of their particular application and may rightly rate as high performance power transistors. This attribute indicating that there are no technological limitations imposed upon the optimization of their parameters by following the teachings of the present invention for forming the power transistors in a "so-called" mixed technology process of fabrication, which, on the other hand, maintains a surprising semplicity being carried out with a minimum number of twelve masking steps.

BRIEF DESCRIPTION OF THE DRAWINGS

The invention and its different aspects and advantages will be more easily understood through the detailed description of the fabrication process used for making the integrated circuits of the invention, with reference to the annexed drawings, wherein:

**Figures from 1 to 25** are schematic enlarged partial cross sections of a semiconductor wafer which show the sequence of operations or process steps in fabricating the circuits in accordance with the present invention. The illustrations focus upon the essential process steps and do not include well known considerations such as for example optional adjustment ion implant operations, particular techniques for opening the contacts, etc.. Moreover, the diffusions are considered complete in the respective cross section depicting their formation even though in reality certain diffusions are interrupted by other intervening implant operations or depositions from gas phases and may not be complete until termination of the sequence of heat treatments to which the wafer being fabricated is subjected.

**Figure 26** shows a schematic cross section of an integrated circuit of the invention, suited for a high voltage operation.

## DESCRIPTION OF THE PREFERRED EMBODIMENT

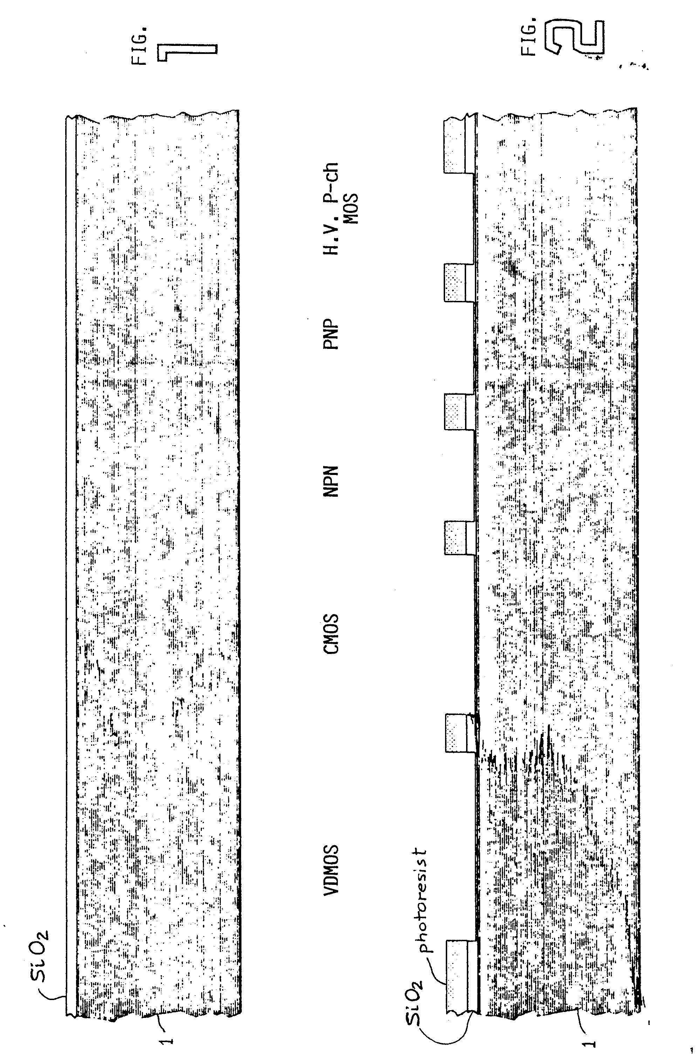

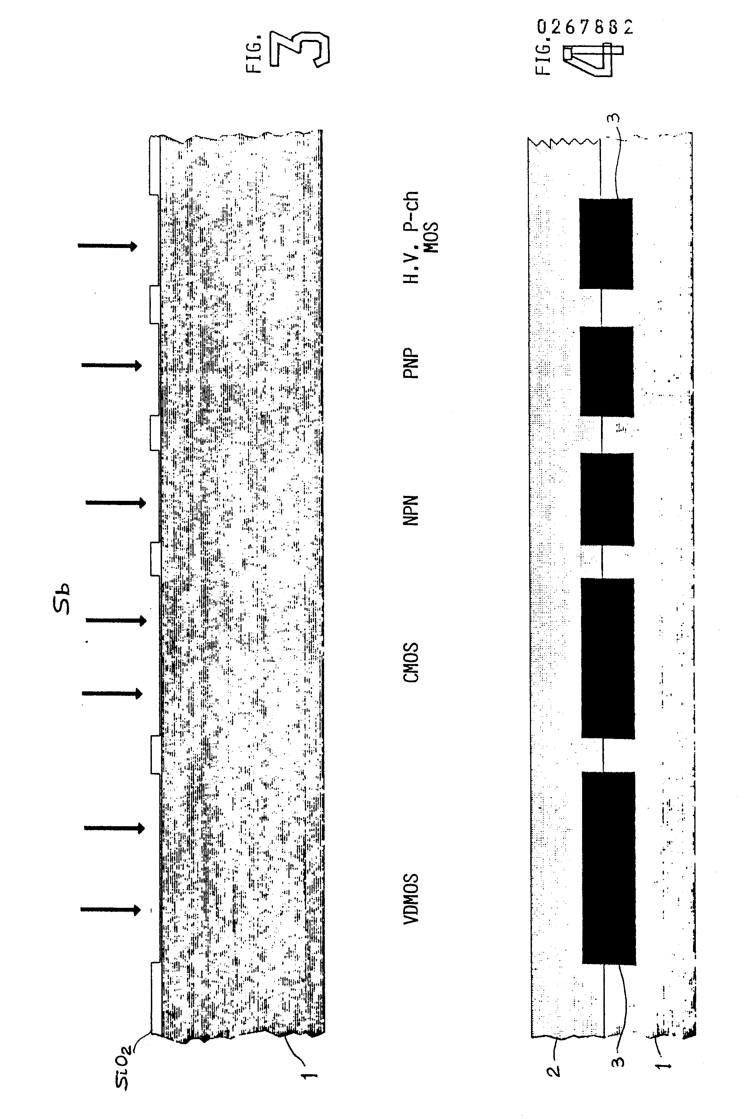

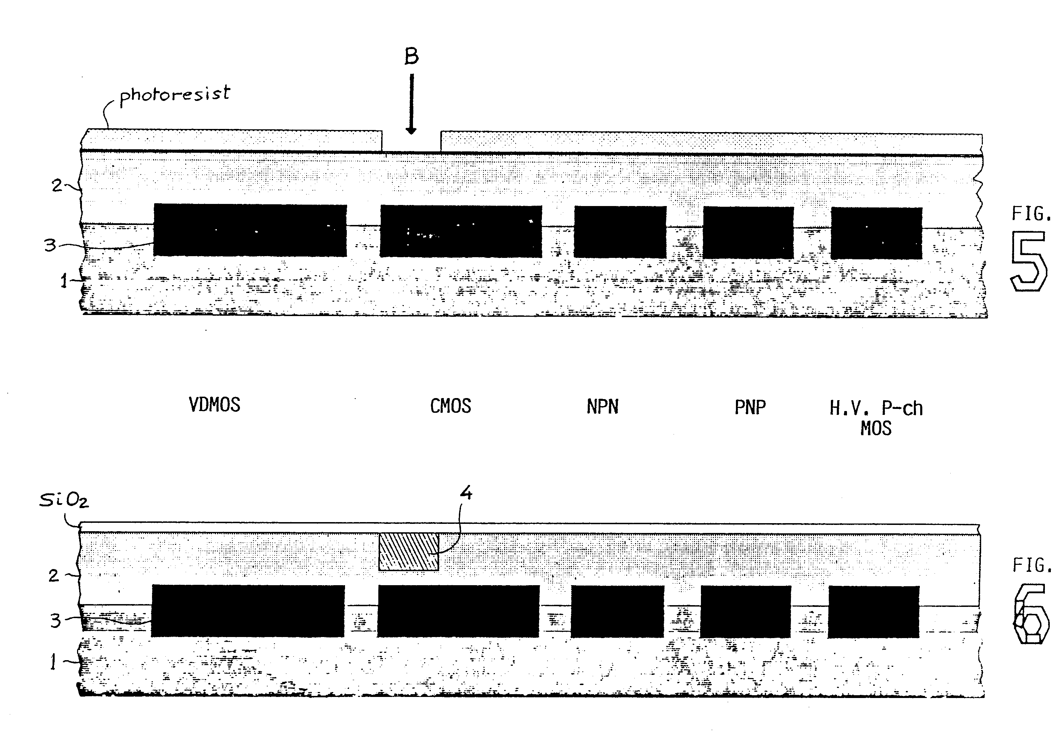

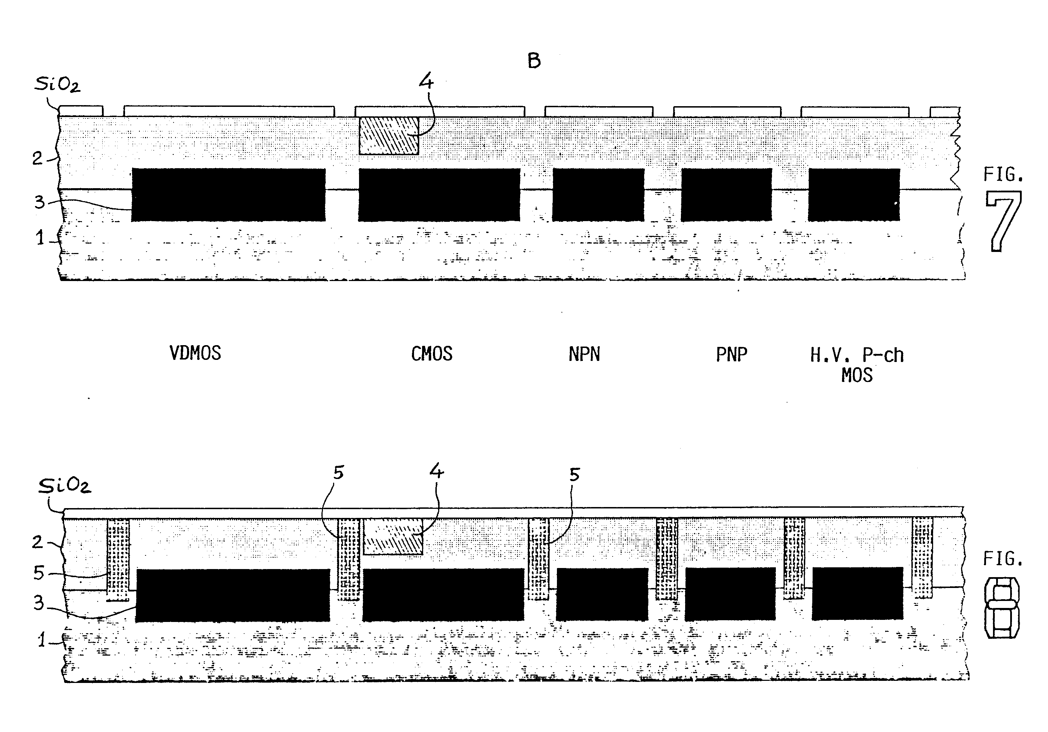

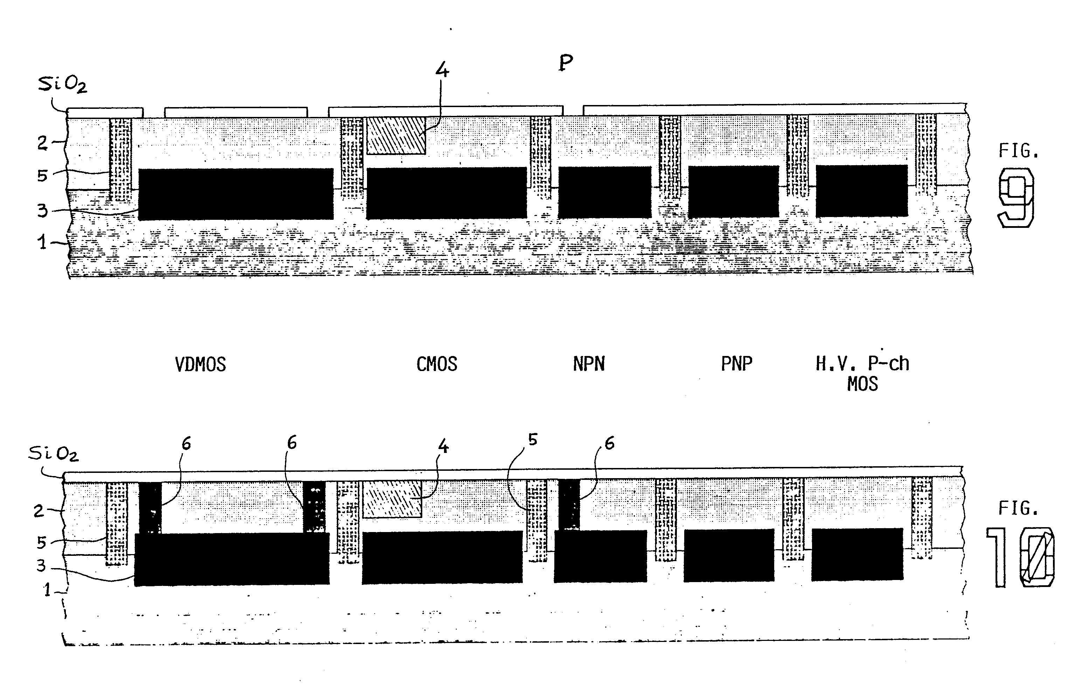

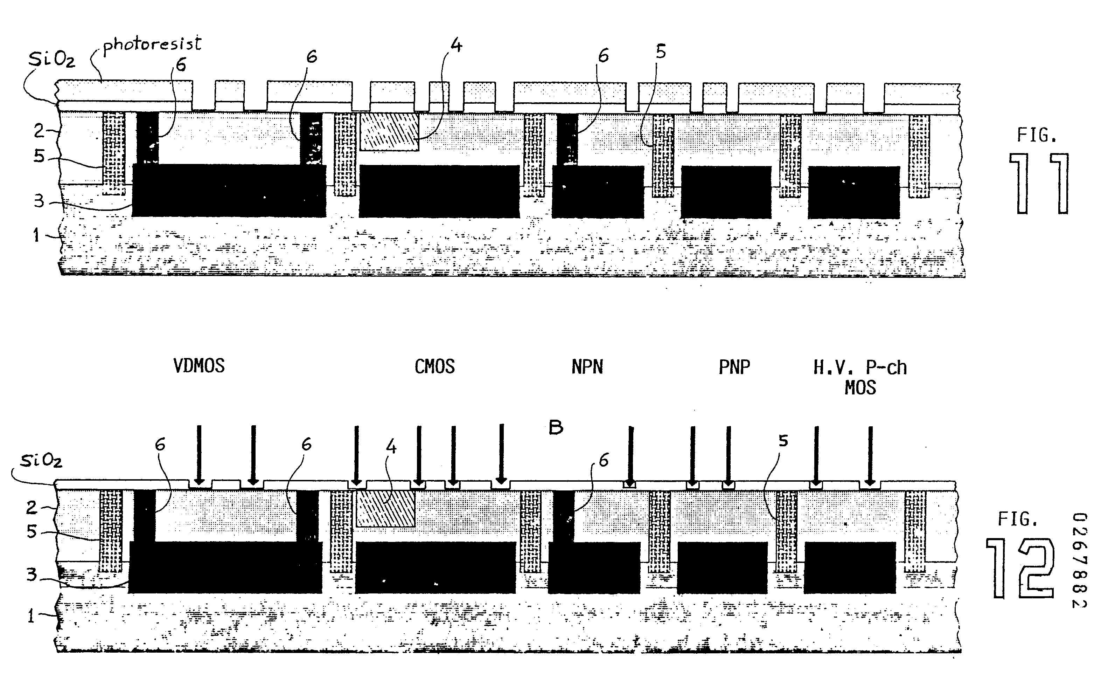

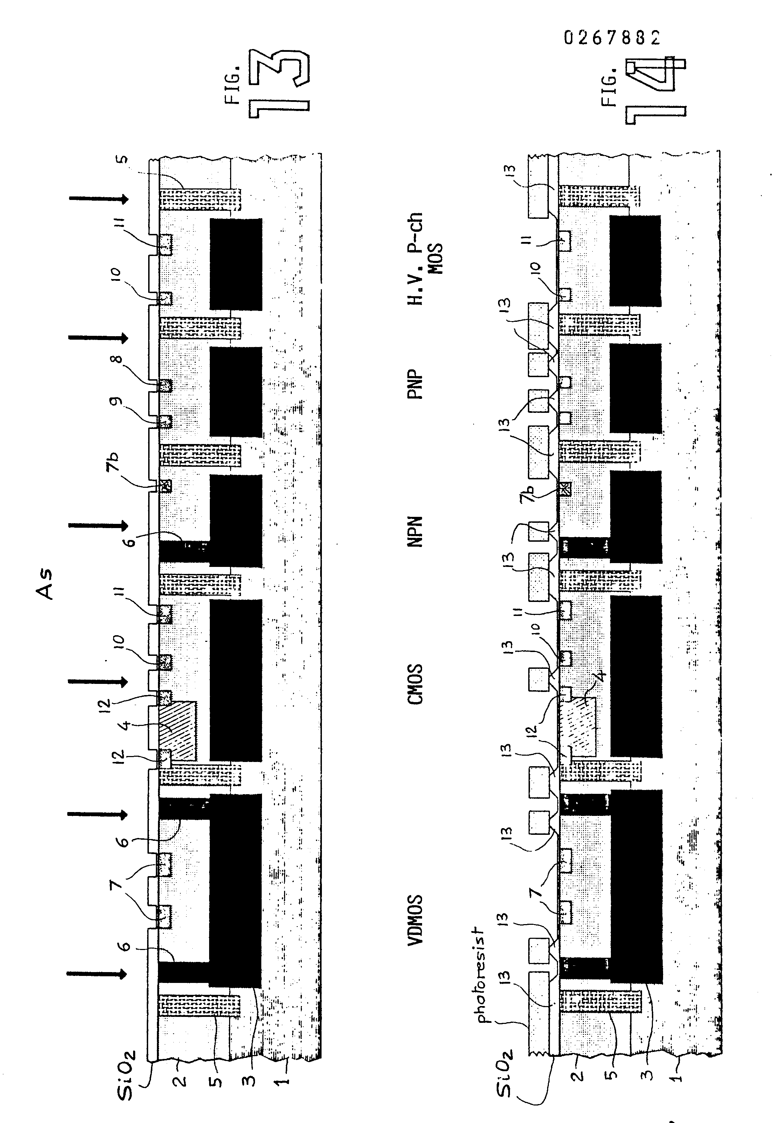

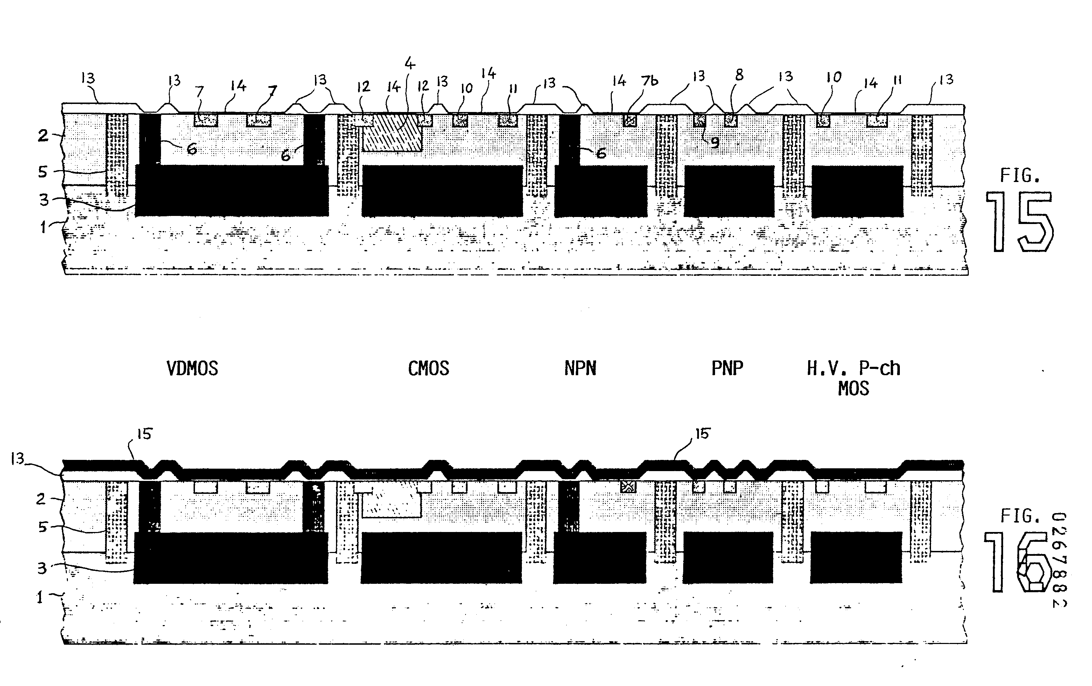

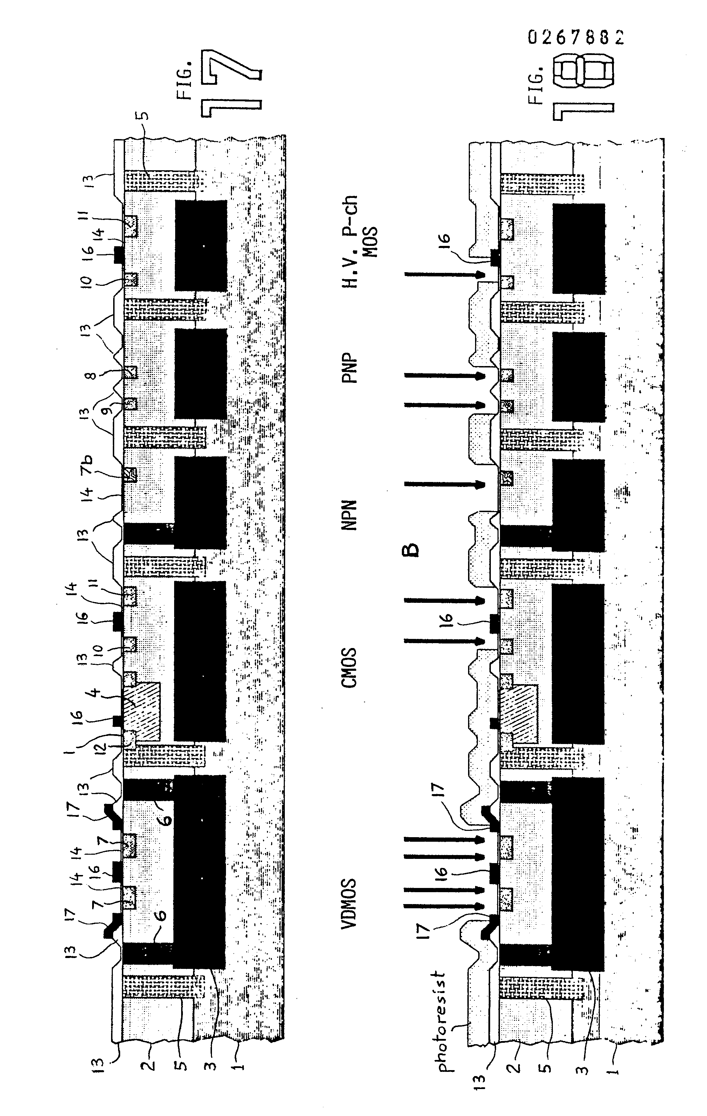

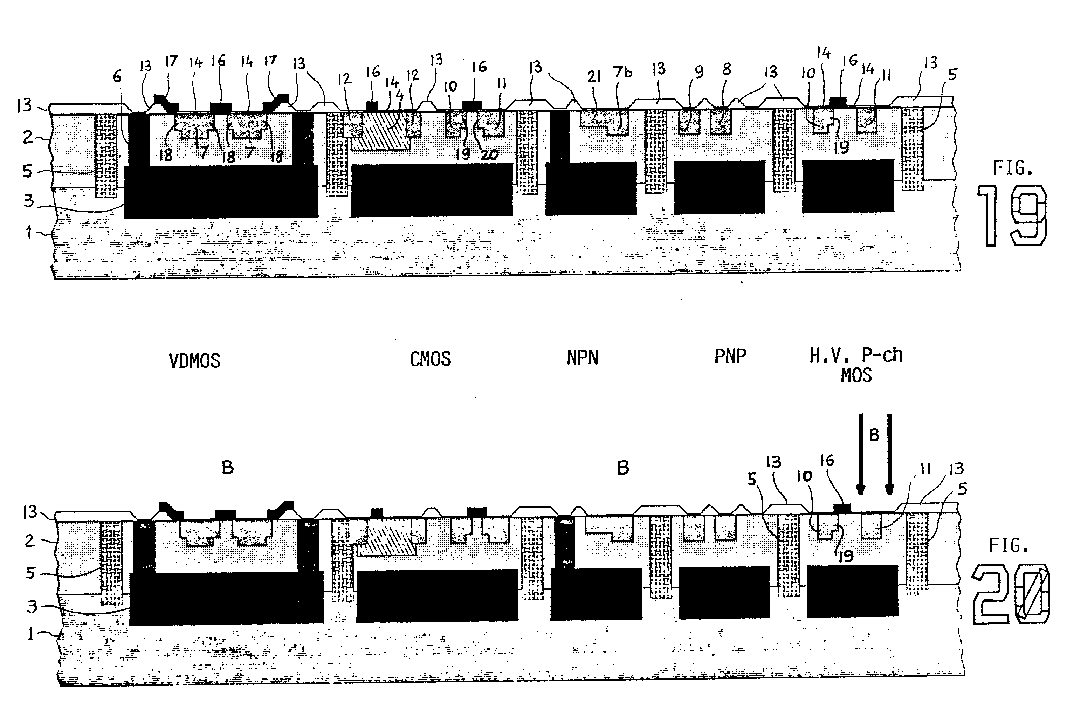

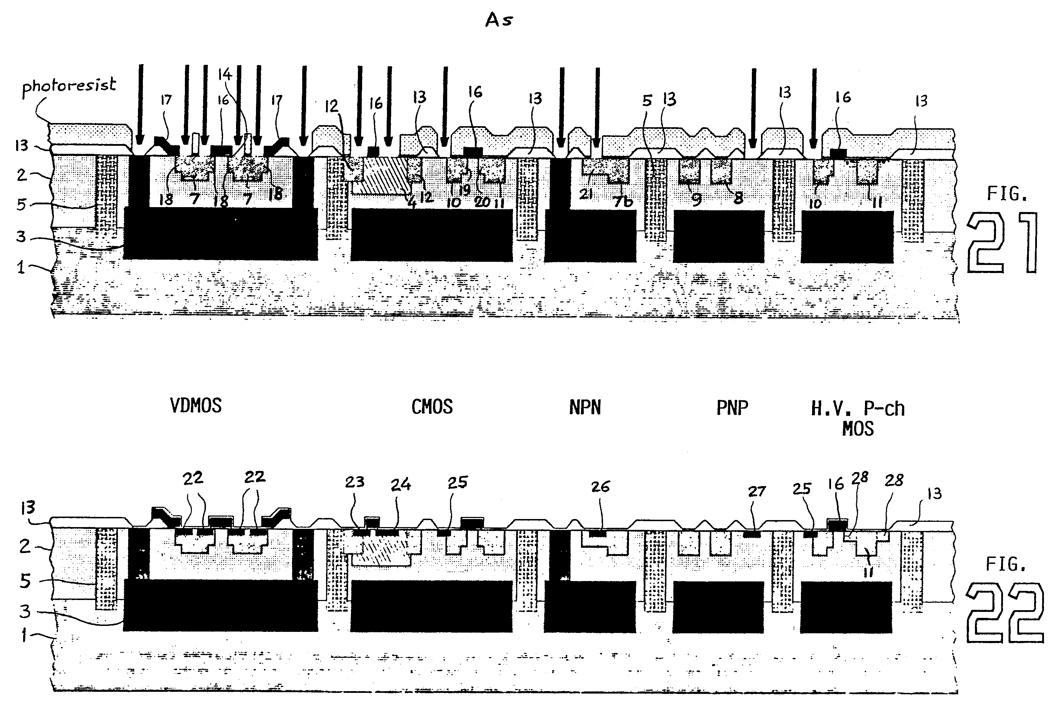

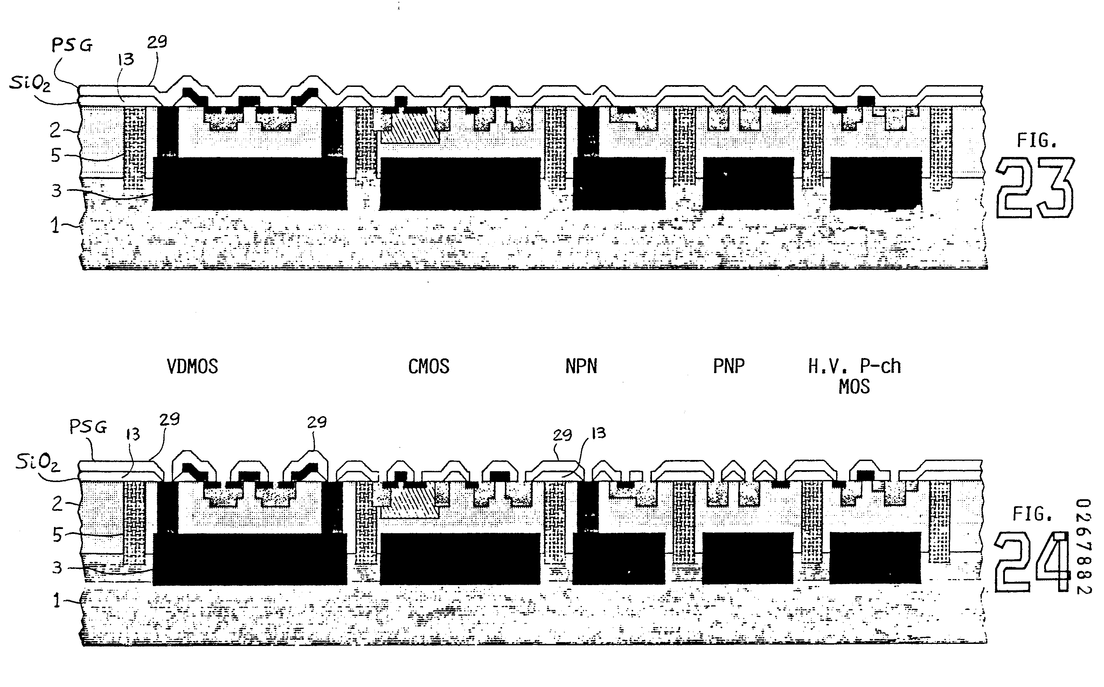

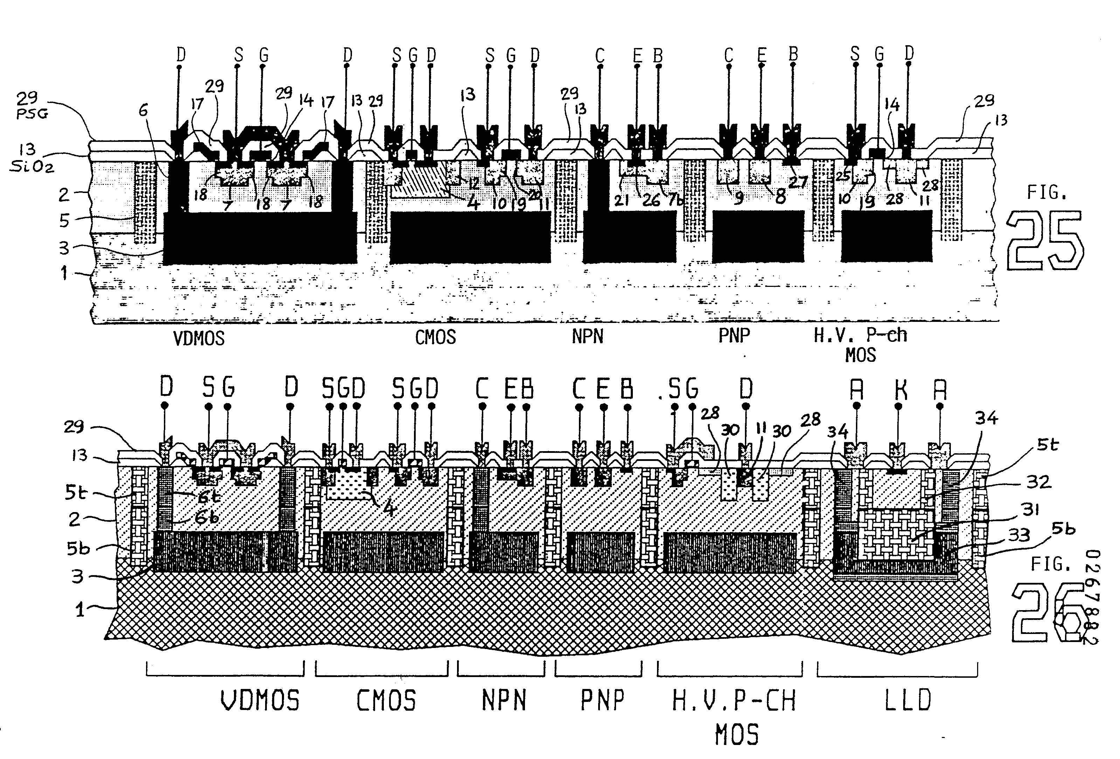

As depicted in Fig. 1, the starting semiconductor wafer 1 is of the P type monocrystalline silicon substrate with a <100> crystallographic orientation, having 2 to 4 ohm.cm bulk resistivity, thermally oxidized until growing an oxide layer of about 7000 Å over the surface. The active areas, respectively destined to the formation of the power VDMOS transistors, of the CMOS transistors, of the NPN transistors, of the PNP transistors and of the high voltage P-channel MOS transistors (H.V. P-ch MOS), are defined by means of a first masking or patterning step with photoresist and by a subsequent plasma attack of the exposed oxide until exposing the underlying monocrystalline silicon as shown in Fig. 2. After removing completely the residual photoresist and thermally re-oxidized the exposed surface of the silicon, a heavy implant of antimony ions is carried out as shown in Fig. 3. After an annealing treatment for eliminating possible crystal damages in the areas implanted with antimony and after an accurate removal of the silicon oxide, the growth of an epitaxial layer 2 of N− type silicon, having a bulk resistivity comprised preferably between 1 and 3 ohm.cm, ensues as shown in Fig. 4. With the epitaxial growth, which takes place at a relatively high temperature, the antimony previously implanted in defined areas of the surface of the substrate 1 diffuses to form said N+ buried layers, indicated with 3 in the figures.

After having slightly oxidized again the silicon surface, a second masking step is performed to define the areas of the P-Well regions and boron ions are implanted through the relative windows, as shown in Fig. 5.

By an oxidizing heat treatment of the wafer until forming a thick layer of oxide, (SiO$_2$), a pre-diffusion of the boron atoms in the silicon of the P-Well regions is also obtained, as shown in Fig. 6.

The areas for making the isolation (top isolations) junctions are defined by a third masking step and the layer of oxide is attacked until exposing the silicon. Through the window, boron is deposited, as shown in Fig. 7.

The wafer is then subjected to a diffusion heat treatment. Boron diffuses through the entire thickness of the epitaxial layer 2, forming the P+ isolation junction 5, simultaneously the diffusion of boron in the P-Well regions 4 progresses. After, the surface of the wafer is again oxidized, as shown in Fig. 8.

The areas through which the contact diffusions with the buried layer 5 for the vertical configuration devices will be formed, are defined by a forth masking step and phosphorus is deposited through the relative windows, as shown in Fig. 9.

Phosphorus is diffused forming the N+ contact diffusions 6 (sinker), and the continuity of the oxide layer over the surface of the wafer is restored again by an appropriate oxidation treatment, as shown in Fig. 10.

By means of a fifth masking step (Fig. 11), the layer of oxide is again attacked to form windows through which a heavy boron implant is effected (Fig. 12) to form heavily doped P+ regions. With this process step the following regions are formed: the central body regions 7 of the VDMOS transistor which are instrumental to reduce the gain of the intrinsic parasitic NPN transistor of the DMOS structure; the emitter 8 and collector 9 regions of lateral (and/or vertical) PNP transistors; P+ type contact regions 10 and 11, respectively for the sources and drains of P-channel MOS transistors, the base region 7b of the NPN transistor (for the embodiment shown in the figures) furthermore, a region 12, known with the name of "channel stopper" region, shaped as a ring around the N-channel MOS transistor of the CMOS structures, as shown in Fig. 13 after having diffused the implanted boron. In the same figure is also shown the implant of arsenic contemplated by a known technique of attacking the silicon oxide layer with an accentuated "undercut" through the openings of an appropriate photoresist mask (sixth masking operation), as shown in the following Fig. 14.

After removing the residual photoresist and after exposing the silicon in the areas uncovered by the thick field oxide layer 13, the gate oxide layer (about 850 Å) thick) is thermally grown and annealed (Fig. 15).

A first level layer of polycrystalline silicon with a thickness of about 4500 Å is deposited by a LPCVD process and the polysilicon 15 is doped with phosphorus (Fig. 16).

The gates 16 of the MOS structures and the field plates 17 of the DMOS power transistors are defined by a seventh patterning step (Fig. 17).

By means of an eighth patterning step (Fig. 18) suitable windows are defined through the photoresist mask for proceeding to a moderate boron implant to define the lateral body extension regions for the power VDMOS transistors, the base region of NPN transistors and the source and drain regions of P-channel MOS transistors. As it may be observed in Fig. 18, the boron implant in the active area of the MOS devices, takes place through "openings" substantially defined by the polysilicon and, in the specific embodiment of the VDMOS power transistor shown, also by the polysilicon field plate 17.

As shown in Fig. 19, by means of a boron diffusion heat treatment, P type lateral extension regions for the body region 7 of VDMOS transistors are formed together with lateral extension P type regions for the source region 19 of P-channel MOS transistors and for the drain region 20 of P-channel MOS transistors of CMOS structures. During the same diffusion heat treatment, the P+ central body regions 7 of the VDMOS transistors and the other P+ regions belonging to the various integrated devices formed before (12, 10, 11, 7b, 9 and 8) extend until reaching substantially their ultimate dimensions.

After having removed the residual photoresist, a light boron implant is carried out (Fig. 20).

The areas destined to the following arsenic implant for creating the N+ tubs are defined by means of a ninth patterning step and subsequent attack of the oxide (Fig. 21). The heavy arsenic implant has the purpose of forming the electrical contact zones in the epitaxial layer, e.g. for the base region of the lateral PNP transistor, for the source regions of the VDMOS transistor, for the source and drain regions of the N-channel MOS transistor, shielded by and self aligned with the relative edge of the gate polysilicon structures, for creating the emitter regions of the NPN transistor, the base region of which may be formed either by utilizing the boron doping profile of the lateral body extension regions of the VDMOS transistors, as depicted in the figures, or by utilizing the boron doping profile of the P-Well regions 4, according to what has been previously discussed.

As shown in Fig. 21, in the structures of VDMOS transistors, the arsenic implant takes place through the same opening through the polysilicon used for implanting boron to create the lateral body extension regions (see Fig. 18).

The cross section of the wafer after having removed the photoresist mask and after having subjected the wafer to a diffusion and superficial oxidation heat treatment is depicted in Fig. 22. In this figure are indicated the N+ source regions 22 of VDMOS transistors, the source 23 and drain 24 regions of N-channel MOS transistors, the body contact region 25 of P-channel MOS transistors, and the emitter region 26 of NPN transistors and the base contact region 27 of PNP transistors. During this diffusion heat treatment, the light amount of boron implanted in the step shown in Fig. 20 diffuses too forming P-- type drain extension regions 28 in high voltage, P-channel, MOS transistors. The boron which was implanted in a light amount without utilizing any mask in the process step depicted in Fig. 20 and which obviously deposited also over other exposed regions, is inhibited from diffusing in these other exposed regions by the following implant and diffusion of arsenic which, in practice, inhibits the diffusion of boron, by exploiting a well known interaction mechanism between the two dopant species.

Source formation in VDMOS devices and source and drain formation in N-channel MOS devices takes place under self-alignment conditions with the respective polysilicon gate structures.

The fabrication process proceeds with a deposition from vapour phase of a layer of phosphorus doped silicon oxide (PSG) 29, with a densifying treatment and with a phosphorus "gettering" deposition followed by a reflow treatment of the vitreous layer, as shown in Fig. 23.

Contact opening is effected by a tenth patterning step, followed by an attack of the composite layer of silicon oxide (PSG + thermally grown $SiO_2$, 29 and 13) (Fig. 24).

A silicon aluminum alloy is deposited and patterned by an eleventh masking step followed by an attack of the aluminum alloy and by a sintering heat treatment, thus forming the metallic interconnections of the different contacts on the front of the integrated circuit (Fig. 25).

An insulating passivating layer (P-vapox or Si3N4) is deposited and the pads areas are defined by means of a twelfth (last) masking procedure. Attack of the passivating layer, finishing and metallization of the rear of the wafer complete the sequence of fabrication steps.

Of course, during the sequence of operations of the fabrication process of the integrated circuit of the invention, other active devices, such as differently structured NPN transistors as mentioned before in the general description of the invention, isolated collector vertical PNP transistors, as well as passive circuit elements such as resistances, capacitances, diodes, low leakage diodes, etc. required by the particular integrated circuit may be easily formed.

The fabrication process may also be modified also by adding further masking steps for implementing special features. For example, when VDMOS power transistors and interface P-channel MOS transistors suitable for operation at voltages in excess of 100-150 V are desired, it is necessary to increase the thickness of the epitaxial layer. In this instance, it may be useful to form the deep electric contact (sinker) regions, the P+ type isolation regions, etc., in two stages, by providing firstly to form so-called bottom isolation (P+) and bottom contact (N+) regions by implanting the relative dopants on defined areas of the substrate before growing the epitaxial layer. The relative diffusion regions are thence reached through so-called top isolation (P+) and sinker (N+) regions.

An example of such an alternative form of the integrated circuit of the present invention is depicted in the schematic section of Fig. 26, showing the structure of an integrated circuit embodying VDMOS power transistors and H.V. P-channel MOS drive transistors designed for an operating voltage in excess of 250 V.

As it may be observed, the P+ isolation zones are obtained by superimposition of a first bottom isolation diffusion 5b and of a top isolation diffusion 5t. Similarly also the N+ contact regions with the buried layer 3 are obtained by superimposition of bottom diffusions 6b and top diffusions 6b.

For very high voltage applications it is possible to further improve the configuration of the drain extension regions of the P-channel drive MOS transistor, by forming around the highly doped central drain region 11 a first drain extension zone 30 by utilizing for the purpose the boron diffusion profile of the P-Well region 4 of N-channel MOS transistors. Immediately outside this first drain extension zone 30, a second, very lightly doped (P--), drain extension region may be formed, as described in connection with Figures 20, 21 and 22. In the section of Fig. 26 is also shown the integration of a low leakage diode (LLD). The P+ region 31 of the diode may be formed by implanting boron on the surface of the substrate in an area comprised within the area over which has been previously implanted antimony for forming the relative N+ buried layer 33. For forming such a N+ buried layer 33, in the case of the low leakage diode, it may be necessary to implant phosphorus beside antimony in order to increase the charge uncompensated by boron within the P+ 31 (the boron diffusing beyond the antimony) and, therefore, to increase the breakdown voltage of the N+ region (33)/P substrate (1) junction. During the high temperature epitaxial growth, both the antimony/phosphorus and the boron will diffuse to oreate, respectively, the N+ buried region 33 and the P+ buried region 31. The P+ contact diffusion 32 with the anodic region 31 is formed during the formation of the top isolation diffusions 5t, while the screen N+ diffusion 34, contacting the N+ region 33 surrounding the anodic region 31, is formed during the formation of the sinker diffusions 6t.

The integrated circuit of the present invention offers outstanding application possibilities in very many fields. In particular, the possibility of integrating power devices and high voltage interfacing (drive) devices together with low leakage diodes, allows to fabricate monolithically integrated systems for the control of DC and stepping motors, which may be driven at the inputs of the integrated circuit by logic level, TTL or CMOS compatible, signals. A device of this kind may drive (in a switched mode) electric motors or inductive loads at high supply voltages and with load DC currents as high as 1.5 - 2 A and is capable of working at high switching frequencies (300 kHz) and with a high efficiency. In transient conditions, the circuit can drive the load with currents up to 5 A for a time limited only by the thermal constant of the "package". The level of dissipated power is also low (about 1.5 W at 1.5 A of load current); this feature makes possible the insertion of the die in a relatively chip DIP package with no need for a heat sink.

## Claims

1. A monolithically integrated circuit comprising:

at least an enhancement type, polysilicon gate, junction isolated, N-channel, VDMOS transistor having an N+ type source region, a P+ type central body region, P type lateral body extension regions, self-aligned with a polysilicon gate electrode and with polysilicon field plates extended over a surrounding field oxide structure, and N- drain epitaxial layers connected to a drain electrode by means of a N+ buried layer and a N+ sinker diffusion;

at least an enhancement type, junction isolated, P-channel, MOS transistor having a P type source extension region, self-aligned with a relative gate electrode and having P-- type drain extension regions on both sides of a P+ type central drain region, said drain extension regions being self-aligned with a polysilicon gate electrode and with a surrounding field oxide structure;

at least another junction isolated, semiconductor device belonging to the group comprising: CMOS transistors, NPN transistors, PNP transistors and low leakage diodes;

a channel region of said VDMOS transistor being defined by the difference between the diffusion distances of respective dopants in said P type lateral body extension regions and in said N+ type source region; and

said P-channel MOS transistor having a reverse breakdown voltage, increased by means of said P-- type drain extension region, higher than the reverse breakdown voltage of said VDMOS transistor.

2. The monolithically integrated circuit according to claim 1, wherein said P-channel MOS transistor has a first P- type drain extension region on both sides of said P+ type central drain region and a second P-- type drain extension region on both sides of said first drain extension region.

3. The monolithically integrated circuit according to claim 1 or 2, characterized by the fact that it is fabricated by means of twelve masking steps.

FIG. 1

SiO₂

1

VDMOS CMOS NPN PNP H.V. P-ch MOS

FIG. 2

SiO₂ photoresist

1

VDMOS CMOS NPN PNP H.V. P-ch MOS

$SiO_2$

$Sb$

FIG. 3

VDMOS          CMOS          NPN          PNP          H.V. P-ch
                                                           MOS

FIG. 4

1

2

3                                                                    3

1

0267882

photoresist

B

2

3

1

FIG. 5

VDMOS  CMOS  NPN  PNP  H.V. P-ch MOS

SiO₂

4

2

3

1

FIG. 6

0267882

FIG. 7

FIG. 8

VDMOS　CMOS　NPN　PNP　H.V. P-ch MOS

FIG. 2

FIG. 1

0267882

FIG. 11

photoresist

$SiO_2$

2
5
3
1

VDMOS CMOS NPN PNP H.V. P-ch MOS

B

$SiO_2$

FIG. 12

0267882

As

SiO₂

6  7  6  12  12  4  10  11  6  7b  9  8  10  11  5

2  5  3  1

FIG. 13

VDMOS    CMOS    NPN    PNP    H.V. P-ch MOS

photoresist

SiO₂  13  13  13  13  13  11  13  7b  13  13  10  11  13

7  12  10

2  5  3  1

FIG. 14

FIG. 15

VDMOS  CMOS  NPN  PNP  H.V. P-ch MOS

FIG. 16

FIG. 17

VDMOS          CMOS          NPN          PNP          H.V. P-ch
                                                          MOS

B

photoresist

FIG. 18

0267882

VDMOS  CMOS  NPN  PNP  H.V. P-ch MOS

FIG. 19

FIG. 20

As

FIG. 21

photoresist

VDMOS          CMOS          NPN          PNP          H.V. P-ch MOS

FIG. 22

FIG. 23

VDMOS       CMOS      NPN     PNP    H.V. P-ch MOS

FIG. 24

FIG. 25

D  S G  D  S G D  S G D  C E B  C E B  S G D

29 PSG

6  17  29  29 14 17  13 29  13  29  13  14  29  13

13
SiO₂

2

5

3

1

18  7  18 7  18  4 10 19 11  21 26 7b  9  8 27  10 19 28 11

12  20  25

VDMOS          CMOS          NPN          PNP          H.V. P-ch
MOS

FIG. 26

D  S G  D  S G D  S G D  C E B  C E B  .S G  D  A K A

29

13

5t

2

5b

3

1

6t  6b  4  28 30 11 30 28 34  34  32  31  33  5b

VDMOS     CMOS     NPN     PNP     H.V.P-CH     LLD
MOS

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PROCEEDINGS OF THE IEEE 1986 CUSTOM INTEGRATED CIRCUITS CONFERENCE, Rochester, New York, 12th-15th May 1986, pages 134-137, IEEE, New York, US; B. MURARI: "Recent developments and trends in intelligent power IC technologies" <br> * Figure 5; page 136: 6 Multipower-BCD * | 1 | H 01 L 27/06 <br> H 01 L 21/82 |
| A | IEEE SPECTRUM, vol. 22, no. 7, July 1985, pages 42-48, New York, US; V. RUMENNIK: "Power devices are in the chips" <br> * Figures 4A,6A * | 1,2 | |
| A | EP-A-0 187 016 (TOSHIBA K.K.) <br> * Claim 1 * | 2 | |

**TECHNICAL FIELDS SEARCHED (Int. Cl.4)**

H 01 L

The present search report has been drawn up for all claims

| Place of search | Date of completion of the search | Examiner |
|---|---|---|
| THE HAGUE | 20-01-1988 | CARDON A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)